# EUROPEAN PATENT APPLICATION

(11) **EP 4 276 860 A1**
(43) Date of publication of application: **15.11.2023**
(21) Application number: 22382453.3
(22) Date of filing: 11.05.2022
(51) Int. Cl.: H01F 27/40, H01F 30/12, H01F 27/26, G01R 15/16, H01F 27/02

(54) **SYSTEM COMPRISING A TRANSFORMER**

(71) Applicant: Hitachi Energy Switzerland AG, 5400 Baden (CH)
(72) Inventor: GARCÍA CHOCANO, Victor Manuel, 50011 Zaragoza (ES); NOGUÉS BARRIERAS, Antonio, 50018 Zaragoza (ES); ROY MARTÍN, Carlos Manuel, 50006 Zaragoza (ES); MURILLO JASO, Rafael, 50004 Zaragoza (ES); CEBRIÁN LLES, Lorena, 50019 Zaragoza (ES); MUÑOZ ARRIBAS, Fernando, 50012 Zaragoza (ES); MORATA ARRUE, María Pilar, 50005 Zaragoza (ES)
(74) Representative: Vossius & Partner Patentanwälte Rechtsanwälte mbB

(57) **Abstract**

The present disclosure relates to a system (10) comprising a transformer (12) which comprises at least one first winding (18) wound around at least one core (14) and at least one second (19) winding wound around the at least one first winding (18). The system (10) further comprises at least one voltage sensor (34) configured and arranged to sense a voltage through the at least one second winding (19) by capacitive coupling.

## Description

### Background

Transformers are widely used to convert electricity from a first voltage level to a second voltage level, the second voltage level being either similar, higher or lower than the first voltage level.

A transformer generally achieves such a voltage conversion by employing at least one primary winding and at least one secondary winding, each being made of electrical conductors. Each of the at least one primary winding and the at least one secondary winding are wound around a core by a plurality of turns.

During operation, transformers may be subjected to one or more transient phenomena, particularly fast transient and very fast transient phenomena, such as an overvoltage, generally as a consequence of one or more events, such as switch operations, lightning strikes, etc. Although transformers are generally configured to withstand such transient phenomena up to a reasonable extent, transient phenomena may lead to a degradation and/or a potential failure of the respective transformer.

Transient phenomena are a matter of concern, in particular since they may result in failures of and/or damages to the transformer which are difficult to predict, at least in a reliable manner. Such failures may reduce the reliability, safety and/or reputation of the transformer and/or may increase the operating costs of the concerned transformer. For instance, the operating costs may include the replacement and/or reparation of the transformer, as well as the costs for investigating the cause(s) and/or the damages caused by the transient phenomena.

Deficiencies remain with respect to dealing with transient phenomena in transformers known from the prior art. Therefore, there is a need to improve a transformer's ability to cope with transient phenomena.

Thus, the present disclosure describes one or more aspect for improving a transformer's ability to cope with transient phenomena, as detailed below.

The present disclosure relates to a system according to a first aspect of the disclosure.

According to a second aspect of the disclosure, an assembly for use in a transformer is described.

Various exemplary embodiments of the present disclosure disclosed herein are directed to providing features that will become readily apparent by reference to the following description when taken in conjunction with the accompanying drawings. In accordance with various embodiments, exemplary systems, methods, and devices are disclosed herein. It is understood, however, that these embodiments are presented by way of example and not limitation, and it will be apparent to those of ordinary skill in the art who read the present disclosure that various modifications to the disclosed embodiments can be made while remaining within the scope of the present disclosure.

Thus, the present disclosure is not limited to the exemplary embodiments and applications described and illustrated herein. Additionally, the specific order and/or hierarchy of steps in the methods disclosed herein are merely exemplary approaches. Based upon design preferences, the specific order or hierarchy of steps of the disclosed methods or processes can be re-arranged while remaining within the scope of the present disclosure. Thus, those of ordinary skill in the art will understand that the methods and techniques disclosed herein present various steps or acts in a sample order, and the present disclosure is not limited to the specific order or hierarchy presented unless expressly stated otherwise.

The above and other aspects and their implementations are described in greater detail in the drawings, the descriptions, and the claims.

### Description of the Drawings

- Fig. 1: shows, in a perspective schematic view, a system according to an embodiment of the disclosure;
- Fig. 2: shows, in a further perspective schematic view, the system of Fig. 1;
- Fig. 3: shows an enlarged view of a section of the system shown in Figs. 1 and 2;
- Fig. 4: shows, in a perspective schematic view, a system according to a further embodiment of the disclosure;
- Fig. 5: shows, in a perspective schematic view, a system according to a further embodiment of the disclosure;
- Fig. 6: shows, in a perspective schematic view, the system of Fig. 5;
- Fig. 7: shows, in a perspective schematic view, the system of Figs. 5 and 6;
- Fig. 8: shows, in a perspective schematic view, the system of Figs. 5 to 7;
- Fig. 9: shows, in a perspective schematic view, a system according to a further embodiment of the disclosure;
- Fig. 10: shows, in a perspective schematic view, a system according to a further embodiment of the disclosure;
- Fig. 11: shows, in a perspective schematic view, a system according to a further embodiment of the disclosure.

In the following, exemplary embodiments of the disclosure will be described. It is noted that some aspects of any one of the described embodiments may also be found in some other embodiments unless otherwise stated or obvious. However, for increased intelligibility, each aspect will only be described in detail when first mentioned and any repeated description of the same aspect will be omitted.

The system according to the first aspect of the present disclosure may comprise a transformer which may comprise at least one first winding wound around at least one core and at least one second winding wound around the at least one first winding. The core may be made of a ferromagnetic material. The at least one first winding and the at least one second winding may be made of an electrically conductive material. The transformer may further comprise at least one first core clamp arranged at a first end of the at least one core and configured to clamp the at least one core, in particular at said first end of the at least one core.

The system may further comprise at least one voltage sensor configured and arranged to sense a voltage through the at least one second winding by capacitive coupling. In other words, the at least one voltage sensor may be configured and arranged to sense a voltage from the at least one second winding by capacitive coupling, e.g., through proximity to the at least one second winding. The at least one voltage sensor may be configured and arranged to sense a voltage from a plurality of second windings, e.g., from second windings of adjacent phases of the transformer. For instance, the at least one voltage sensor may be configured and arranged to sense a voltage composed of 50% of a voltage of one second winding and 50% of a voltage of a further second winding. For instance, the at least one voltage sensor may be arranged at least partially between the second windings of two adjacent phases. Particularly, the at least one voltage sensor may be at least partially arranged at a position, which lies in a plane which extends between the second windings of two adjacent phases and/or which lies in a plane which extends substantially parallel to and between, preferably with substantially equal distances to, longitudinal axes of the legs of the two adjacent phases. This may enable the at least one voltage sensor to be positioned relatively closely to the second windings and relatively far from the first windings. This may isolate the sensed signal to the voltage through the second windings to a relatively large extent. Further alternatively, the at least one voltage sensor may be configured and arranged to sense a voltage from one or more first windings and one or more second windings, e.g., from first windings and second windings of adjacent phases of the transformer.

As discussed at the beginning, transient phenomena, particularly fast transient and very fast transient phenomena, such as an overvoltage, may lead to a degradation and/or a potential failure of the respective transformer. Moreover, transient phenomena may result in failures of and/or damages to the transformer which are difficult to predict, at least in a reliable manner. Furthermore, a determination of the source of transient phenomena is often complex since it often involves resonant and high-frequency phenomena of the transformer itself as well as the surrounding installation elements.

Hence, the present disclosure provides the at least one voltage sensor configured and arranged to sense a voltage from the at least one second winding by capacitive coupling. The at least one voltage sensor may thus be configured to monitor a voltage of the at least one second winding by capacitive coupling in order to detect transient phenomena, particularly fast transient and very fast transient phenomena, such as an overvoltage, by sensing a voltage through the at least one second winding. The system, in particular the at least one voltage sensor, may be configured to detect transient phenomena as the transient phenomena is occurring and/or prior to the occurrence of transient phenomena. For instance, the system may be configured to detect one or more events, e.g., one or more switch operations and/or one or more lightning strikes, which may result in one or more transient phenomena and/or which may indicate one or more transient phenomena. This may allow the system to predict an occurrence of one or more transient phenomena in the transformer.

The system may be configured to generate and/or store data based on the sensed voltage(s), and optionally based on further data acquired by the system. This may allow the system to process and analyse the data. The system may be configured to apply artificial intelligence, e.g., machine learning, such as by means of one or more processing devices, in particular a central processing unit, such that the prediction of transient phenomena based on the sensed voltage(s), and optionally based on further data acquired by the system, may be improved. The system may be configured to transmit the data wirelessly, e.g., via Wi-Fi and/or Bluetooth, between components of the system, e.g., from the at least one voltage sensor to one or more processing devices, and/or between at least one component of the system and at least one external device, such as an external evaluating device and/or processing device, e.g., a customer device, such as a mobile device, e.g., a smart device, or a computer. This may reduce the cabling efforts of the system, which may provide a safer and tidy environment within and/or around the system. Alternatively, or additionally, the system may be configured to transmit the data via one or more hard connections, e.g., via one or more cables and/or one or more fiber optics.

The system may be configured, e.g., by means of one or more processing devices communicatively coupled to the at least one voltage sensor, to assess the sensed voltage, or plurality of sensed voltages, based on one or more criteria. The system may be configured to generate at least one signal, e.g., at least one warning signal, if the sensed voltage, or plurality of sensed voltages, meet(s) and/or do(es) not mean one or more of the one or more criteria. By providing a warning signal, an operator and/or user of the transformer may be notified that one or more transient phenomena is/are occurring and/or has occurred and/or will occur in the future. This may allow the operator and/or user of the transformer to take one or more countermeasures, such as by providing a Transient Voltage Protection (TVP), or adapt and/or exchange, e.g., improve, an already present countermeasure, such as a TVP. This may enable damage to or failure of the transformer to be prevented or at least mitigated and/or delayed.

For instance, the one or more criteria may include one or more voltage thresholds, wherein the system may be configured to generate the at least one signal, e.g., at least one warning signal, if the sensed voltage, or plurality of sensed voltages, is larger or less than at least one of the one or more voltage thresholds. The one or more criteria may include at least one range, wherein the system may be configured to generate the at least one signal, e.g., at least one warning signal, if the sensed voltage, or plurality of sensed voltages, fall(s) within or outside of at least one of the at least one range. The one or more criteria may be predetermined. At least one criterion of the one or more criteria may be a fixed criterion. At least one criterion of the one or more criteria may be an adaptive criterion, e.g., the adaptive criterion may adapt and/or may be adapted, in particular automatically by the system, to the respective transform and/or to the operating condition of the respective transform.

Alternatively, or additionally, the system may be configured to generate the at least one signal, e.g., at least one warning signal, if the number of detected one or more events and/or the number of times the sensed voltage(s) meet(s) and/or do(es) not mean one or more of the one or more criteria exceeds a certain number or range and/or their occurrence rate exceeds or does not exceed a threshold.

The at least one voltage sensor may be retrofittable to already existing transformers and/or transformers which are already built and/or in operation. For instance, the at least one voltage sensor may be mountable to a casing of the transformer, wherein the casing may at least partially enclose or house one or more components of the transformer, particularly the at least one first winding, the at least one second winding and the at least one core. The casing may be a casing of a dry-type transformer. The casing may also be a casing of an oil-immersed transformer, wherein the casing may at least partially contain an oil of the oil-immersed transformer. The term "casing" may refer to a housing, enclosure, compartments, or any structure that may completely or at least partially encompass one or more components of the transformer.

The at least one voltage sensor may be mounted such that the at least one voltage sensor is located at a predetermined distance to at least one section of the at least one second winding. The at least one voltage sensor may be mounted such that the predetermined distance between the at least one voltage sensor and the at least one section of the at least one second winding is substantially maintained, or only minimally changed, during operation of the system and/or when the entire system is displaced, e.g., when the system is transport from the manufacturer to a customer site. This may increase the reliability and/or precision in sensing the voltage through the at least one second winding and determining whether transient phenomena is occurring and/or will be occurring in the future by means of the at least one voltage sensor. Moreover, the at least one voltage sensor is generally calibrated prior to operation of the system. In case the distance between the at least one voltage sensor and the at least one section of the at least one second winding is altered after calibration, the calibration may have to be repeated and/or adjusted. Hence, by maintaining the distance between the at least one voltage sensor and the at least one section of the at least one second winding, the calibration may remain valid. This may allow another calibration process and/or adapting the first calibration to be omitted.

The system may include at least one or more processing devices, in particular a central processing unit, configured to acquire at least one or more sensing signals from the at least one voltage sensor and process the one or more signals. The one or more processing devices may be configured to digitize, e.g., by means of at least one analog-to-digital converter, the one or more sensing signals.

The at least one voltage sensor may be mounted such that a certain distance, particularly a predetermined minimum distance, is kept/maintained from the at least one second winding. Particularly, the at least one voltage sensor may be mounted such that the at least one voltage sensor is within a range, particularly a predetermined range, e.g., within a range from a maximum distance to a minimum distance, particularly a predetermined minimum distance, of the at least one second winding. By reducing the distance between the at least one voltage sensor and the at least one second winding, a reception of undesired signals, such as from a nearby further winding and/or a nearby further transformer and/or nearby electronic devices, may be prevented or at least reduced.

For this purpose, the at least one voltage sensor may be mounted in the vicinity of the at least one second winding, but at a safe distance, e.g., at least by a predetermined distance, from the at least one second winding and/or from the at least one first winding and/or one or more leads and/or one or more cables and/or busbars connected to the leads of the transformer. This may allow the system to reliably and/or relatively precisely sense the voltage from the at least one second winding, while enhancing the system's ability of preventing an arc and/or a partial discharge.

The at least one voltage sensor may be mounted to a section of the transformer and/or on a section of a structure in the vicinity of the transformer, e.g., on a wall or other structure in a room in which the transformer is located or will be located. Alternatively, the at least one voltage sensor may be mounted on the at least one core clamp. Alternatively, the at least one voltage sensor may be mounted on a casing of the transformer. In general, the at least one voltage sensor may be mounted on at least near one or more earthed components, e.g., one or cables and/or the at least one core clamp and/or an additional grounded component, such as a capacitor and/or a resistor.

The system may comprise a plurality of voltage sensors. Each of the plurality of voltage sensors may be mounted to a different surface or structures. For instance, at least one first voltage sensor may be mounted on the at least one core clamp and at least one second voltage sensor may be mounted in the vicinity of the transformer, e.g., on a wall or other structure in a room in which the transformer is located. Alternatively, or additionally, at least one first voltage sensor may be mounted on a casing of the transformer and at least one second voltage sensor may be mounted on the at least one core clamp.

The at least one voltage sensor, as referred to herein, may refer to the actual physical sensing means for physically sensing a voltage through the at least one second winding by capacitive coupling. The at least one voltage sensor may be included in at least one voltage sensor unit which may further include, e.g., at least one processing unit, one or more cables and/or one or more further devices or elements, such as one or more means for attaching the at least one voltage sensor to at least one surface. The at least one voltage sensor may be integrated in a printed circuit board (PCB).

The at least one voltage sensor may be configured as a patch, e.g., a relatively flat structure. In particular, the at least one voltage sensor may have at least one mounting surface configured to be mounted to an object, e.g., a surface of the transformer or any other surface, in particular in the vicinity of the transformer. The at least one voltage sensor may include, in particular house, an electrode or a pair of electrodes.

The at least one first winding may be a low voltage (LV) winding of the transformer and the at least one second winding may be a high voltage (HV) winding of the transformer, the HV winding having a voltage which is higher than the voltage of the LV winding.

The at least one first winding may be a primary winding and the at least one second winding may be a secondary winding. Alternatively, the at least one second winding may be a primary winding and the at least one first winding may be a secondary winding. The primary coil windings may be connected to a source of voltage and the secondary coil winding may be connected to a load or vice versa.

The transformer may be a low voltage, medium voltage or high voltage transformer. The transformer may be configured as a liquid-cooled, e.g., liquid-immersed, such as an oil-filled or oil-immersed, transformer. Alternatively, the transformer may be configured as a dry transformer, e.g., not immersed in, a liquid, e.g., oil.

The system may further comprise the at least one core and at least one first core clamp arranged at a first end of the at least one core and configured to clamp the at least one core at the first end. The at least one voltage sensor may be connected to a surface of the at least one first core clamp.

At least one lead of the at least one second winding may be connected to the transformer at a connection section. In particular, the at least one lead may also be referred to as a terminal, e.g., a high voltage (HV) lead or terminal. The at least one voltage sensor may be connected to a surface of the transformer, particularly to a surface of the at least one first core clamp. The surface of the transformer may face in a direction away from the connection section and/or may be arranged on a first side of a vertical central plane of the transformer, the first side being substantially opposite of a second side of the vertical central plane, the at least one lead being arranged on the second side. Arranging the at least one voltage sensor on a surface of the transformer which faces in a direction away from the connection section and/or on a first side of a vertical central plane of the transformer which is substantially opposite of the at least one lead may reduce the extent to which the voltage through the at least one lead and/or one or more cables and/or busbars connected to the at least one lead, is sensed by the at least one voltage sensor. Generally speaking, it may be undesirable to sense voltage through the at least one lead and/or one or more cables and/or busbars connected to the at least one lead. Instead, it may be desirable to isolate the sensed signal to the voltage through the at least one second winding as much as possible. This may, for instance, increase the reliability and precision of a calibration process, which generally does not take into account the voltage through the at least one lead and/or one or more cables and/or busbars connected to the at least one lead. As discussed at the beginning, core clamps are generally earthed. Thus, connecting the at least one voltage sensor to a surface of the at least one first core clamp may provide a region for the at least one voltage sensor to reliably, safely and precisely, relatively speaking, sense the voltage through the at least one second winding. Moreover, the at least one first core clamp may provide an attachment and/or guiding means for attaching and/or guiding one or more wires/cables which are connected to the at least one voltage sensor, e.g., for transmitting one or more signals to and/or from the at least one voltage sensor. In addition, one or more processing devices, in particular a central processing unit, may be attached and/or stowed in and/or on the at least one first core clamp.

Generally speaking, positioning the at least one voltage sensor near, or at least closer, to one or more leads of the transformer and/or one or more cables and/or busbars connected to the one or more leads is possible. However, this may require greater efforts directed towards electrical insulation between the at least one voltage sensor and the respective lead(s). For instance, this may require more insulation material, e.g., having a greater thickness, and/or a different insulation material to be employed between the at least one voltage sensor and the respective lead(s) and/or cables or busbars, e.g., at least partially about the respective lead(s). If the at least one voltage sensor is positioned further from the respective lead(s), less effort, e.g., costs, directed towards the insulation may be required/sufficient.

The at least one voltage sensor may be arranged, particularly connected to the at least one first core clamp, at a first angular location about a longitudinal axis of the transformer and the at least one lead is connected to the transformer at a second angular location. The longitudinal axis of the transformer may be a winding axis about which the at least one first winding and/or the at least one second winding are wound. The first angular location may be offset from the second angular location by a predetermined offset angle. In an operable state of the transformer, the longitudinal axis of the transformer may extend vertically. The first angular location may be offset from the second angular location by at least 90°, particularly by at least 120°, more particularly by at least 150°, most particularly by substantially 180°. This may also, or further, reduce the extent to which the voltage through the at least one lead and/or one or more cables and/or busbars connected to the at least one lead and conducting electricity to or from the at least one lead, is sensed by the at least one voltage sensor, e.g., by providing a predetermined (minimum) distance between the at least one lead and the at least one voltage sensor via an angular offset therebetween.

At least one voltage sensor, e.g., the at least one voltage sensor described above or a further voltage sensor of a plurality of voltage sensors configured and arranged to sense a voltage through the at least one second winding by capacitive coupling included in the transformer, may be connected to a surface of the transformer, particularly to a surface of the at least one first core clamp. The surface may be arranged on the same side of a vertical central plane of the transformer as the at least one lead. Generally, a transformer is provided with at least one second lead connected to the at least one first winding, e.g., at least one low voltage (LV) winding. The at least one second lead is generally arranged vis-a-vis, i.e., on an opposite of the transformer, from the lead connected of the at least one second winding. Hence, positioning the at least one voltage sensor on the same side of a vertical central plane of the transformer as the lead connected to the at least one second winding may increase the distance from the at least one second lead of the at least one first winding. This may reduce the extent to which the voltage through the at least one second lead of the at least one first winding and/or one or more cables and/or busbars connected to the at least one second lead, is sensed by the at least one voltage sensor. As discussed above, generally speaking, it may be undesirable to sense voltage through a lead of the transformer, e.g., the at least one second lead of the at least one first winding and/or one or more cables and/or busbars connected to the lead. Thus, it may be desirable to isolate the sensed signal to the voltage through the at least one second winding as much as possible.

The transformer may comprise at least one second core clamp at a second end of the at least one core, the second end of the at least one core being arranged substantially opposite of the first end of the at least one core, the second core clamp being configured to clamp the at least one core at the second end of the at least one core. The at least one voltage sensor may be connected to a surface of the at least one first core clamp and/or to a surface of the at least one second core clamp. The arrangement of the at least one voltage sensor on the at least one second core clamp may be configured analogously to the arrangement of the at least one voltage sensor on the at least one first core clamp, as described above.

At least one lead of the at least one first winding may be arranged at the first end or a second end of the at least one core, the second end being substantially opposite of the first end of the at least one core. The at least one voltage sensor may be arranged at the other of the first end and the second end of the at least one core. Thus, if the at least one lead of the at least one first winding is arranged at the first end of the at least one core, the at least one voltage sensor may be arranged at the second end of the at least one core. Vice versa, if the at least one lead of the at least one first winding is arranged at the second end of the at least one core, the at least one voltage sensor may be arranged at the first end of the at least one core. This may reduce, or further reduce, the extent to which the voltage through the at least one lead of the at least one first winding and/or one or more cables and/or busbars connected to the at least one lead of the at least one first winding, is sensed by the at least one voltage sensor. This may further isolate the sensed signal to the voltage through the at least one second winding.

The first end of the at least one core and/or the second end of the at least one core may be a distal end or end section of the at least one core. The first end of the at least one core and/or the second end of the at least one core may be arranged at, within or near, a respective core clamp, e.g., the at least one first core clamp or the at least one second core clamp. Accordingly, the at least one voltage sensor may be arranged at, within or near, a respective core clamp, the at least one first core clamp or the at least one second core clamp.

The at least one voltage sensor may be attached to one end of the at least one core. In particular, the at least one voltage sensor may be attached to a surface of a yoke of the at least one core.

The transformer may further comprise at least one casing. The at least one casing may be connected to the at least one first core clamp. The at least one voltage sensor may be connected to the at least one casing. The at least one casing may house, at least partially or completely, the at least one second winding. The at least one casing may be mechanically coupled, e.g., via one or more mechanical connection elements, such as rivets or bolts, to the at least one first core clamp. The at least one voltage sensor may be mechanically coupled, e.g., via one or more mechanical connection elements, such as rivets or bolts, and/or adhesively coupled to the at least one casing. The at least one casing may be directly connected or indirectly connected, e.g., via one or more connection elements, to the at least one first core clamp. The at least one voltage sensor may be directly connected or indirectly connected, e.g., via one or more connection elements, to the at least one casing.

The at least one voltage sensor may be attached to an outer surface of the casing, e.g., facing away from the at least one second winding, or an inner surface of the casing, e.g., facing towards the at least one second winding.

The transformer may be an oil-filled transformer and the casing may house the oil.

The at least one second winding may be a low voltage winding and the at least one first winding may be a high voltage winding of the transformer.

The at least one voltage sensor may have a rounded shape, in particular a spherical, a hemispherical, a toroidal, or a hemi toroidal shape. Configuring the at least one voltage sensor to have a rounded shape may prevent, or at least reduced the risk, of an arc and/or a partial discharged occurring between the at least one voltage sensor and the windings, lead(s) of the transformer and/or one or more cables and/or busbars connected to the lead(s) of the transformer. In particular, the at least one voltage sensor may not have any sharp edges or at least some or most of the edges of the at least one voltage sensor may be rounded.

The largest area of projection of the at least one voltage sensor may be no more than 500 cm2, particularly no more than 450 cm2, more particularly no more than 400 cm2, more particularly no more than 350 cm2, more particularly no more than 300 cm2, more particularly no more than 250 cm2, more particularly no more than 200 cm2. This may reduce, or at least limit, the space occupied by the at least one voltage sensor. This may increase the visual and/or aesthetic appeal of the system, e.g., to persons, such as customers or visitors, viewing the system. Additionally, or alternatively, this may reduce the cost of the at least one voltage sensor, e.g., by reducing the required material for the at least one voltage sensor. Additionally, or alternatively, this may reduce the risk that the at least one voltage sensor may accidentally be displaced, e.g., by colliding with the at least one voltage sensor while performing maintenance and/or service on the system. Additionally, or alternatively, this may reduce the risk of causing an insulation failure, e.g., at one or more leads of the transformer, e.g., due to the reduced, or at least limited, space occupied by the at least one voltage sensor. Additionally, or alternatively, this may reduce the risk of an arc and/or a partial discharge, e.g., due to the smaller area of the at least one voltage sensor.

The largest spatial dimension of the at least one voltage sensor may be no more than 20 cm, particularly no more than 18 cm, more particularly no more than 16 cm, more particularly no more than 14 cm, more particularly no more than 12 cm. This may also reduce, or limit, or further reduce or further limit, the space occupied by the at least one voltage sensor. The advantageous effects provided thereby are described above.

The at least one voltage sensor may have a spatial volume of no more than 700 cm3, particularly no more than 650 cm3, more particularly no more than 600 cm3, more particularly no more than 550 cm3, more particularly no more than 500 cm3. This may also reduce, or limit, or further reduce or further limit, the space occupied by the at least one voltage sensor. The advantageous effects provided thereby are described above.

The following list of aspects provides alternative and/or further features of the disclosure:
1. A system comprising:
   a transformer comprising:
      at least one first winding wound around at least one core,
      at least one second winding wound around the at least one first winding,
   and
   at least one sensor, in particular at least one voltage sensor, configured and arranged to sense at least one signal, in particular at least one voltage, from the at least one first winding and/or at least one signal, in particular at least one voltage, from the at least one second winding, in particular by capacitive coupling.
2. The system of aspect 1, further comprising the at least one core and at least one first core clamp arranged at a first end of the at least one core and configured to clamp the at least one core at the first end, wherein the at least one voltage sensor is connected to a surface of the at least one first core clamp.
3. The system of aspect 1 or 2, wherein at least one lead of the at least one second winding is connected to the transformer at a connection section, wherein at least one voltage sensor is connected to a surface of the transformer, particularly to a surface of the at least one first core clamp, wherein the surface to which the at least one voltage sensor is connected:
   faces in a direction away from the connection section;
   and/or
   is arranged on a first side of a vertical central plane of the transformer, the first side being substantially opposite of a second side of the vertical central plane, the lead being arranged on the second side.
4. The system of any one of aspects 1 to 3, wherein the at least one voltage sensor is arranged, particularly connected to the at least one first core clamp, at a first angular location about a longitudinal axis of the transformer and the lead is connected to the transformer at a second angular location, wherein the first angular location is offset from the second angular location by a predetermined offset angle.
5. The system of any one of aspects 1 to 4, wherein at least one voltage sensor is connected to a surface of the transformer, particularly to a surface of the at least one first core clamp, wherein the surface is arranged on the same side of a vertical central plane of the transformer as the lead.
6. The system of any one of aspects 2 to 5, wherein the transformer comprises at least one second core clamp at a second end of the at least one core, the second end of the at least one core being arranged substantially opposite of the first end of the at least one core, the second core clamp being configured to clamp the at least one core at the second end of the at least one core, wherein the at least one voltage sensor is connected to a surface of the at least one first core clamp and/or to a surface of the at least one second core clamp.
7. The system of any one of aspects 1 to 6, wherein a lead of the at least one first winding is arranged at the first end or a second end of the at least one core, the second end being substantially opposite of the first end, wherein the at least one voltage sensor is arranged at the other of the first end and the second end.
8. The system of any one of aspects 1 to 7, wherein the at least one voltage sensor is attached to one end of the at least one core.
9. The system of any one of aspects 1 to 8,
   wherein the transformer further comprises at least one casing,
   wherein the at least one casing is connected to the at least one first core clamp and the at least one voltage sensor is connected to the at least one casing, and
   wherein the casing houses the at least one second winding.
10. The system of aspect 9, wherein the at least one voltage sensor is attached to an outer surface of the at least one casing.
11. The system of aspect 9 or 10, wherein the transformer is an oil-filled transformer and the at least one casing houses the oil.
12. The system of any one of aspects 9 to 11, wherein the at least one voltage sensor is attached to an inner surface of the at least one casing, particularly facing the at least one second winding.
13. The system of any one of aspects 1 to 12, wherein the at least one second winding is a high voltage winding and the at least one first winding is a low voltage winding of the transformer.
14. The system of any one of aspects 1 to 13, wherein the at least one voltage sensor has a rounded shape, in particular a spherical, a hemispherical, a toroidal, or a hemi toroidal shape.
15. The system of any one of aspects 1 to 14, wherein the largest area of projection of the at least one voltage sensor is no more than 500 cm2, particularly no more than 450 cm2, more particularly no more than 400 cm2, more particularly no more than 350 cm2, more particularly no more than 300 cm2, more particularly no more than 250 cm2, more particularly no more than 200 cm2.
16. The system of any one of aspects 1 to 15, wherein the largest spatial dimension of the at least one voltage sensor is no more than 20 cm, particularly no more than 18 cm, more particularly no more than 16 cm, more particularly no more than 14 cm, more particularly no more than 12 cm.
17. The system of any one of aspects 1 to 16, wherein the at least one voltage sensor has a spatial volume of no more than 700 cm3, particularly no more than 650 cm3, more particularly no more than 600 cm3, more particularly no more than 550 cm3, more particularly no more than 500 cm3.
18. A transformer assembly, comprising:
   at least one first winding configured to be wound around at least one core,
   at least one second winding wound or configured to be wound around the at least one first winding, and,
   at least one voltage sensor configurable and arrangeable to sense a voltage through the at least one first winding and/or a voltage through the at least one second winding by capacitive coupling.

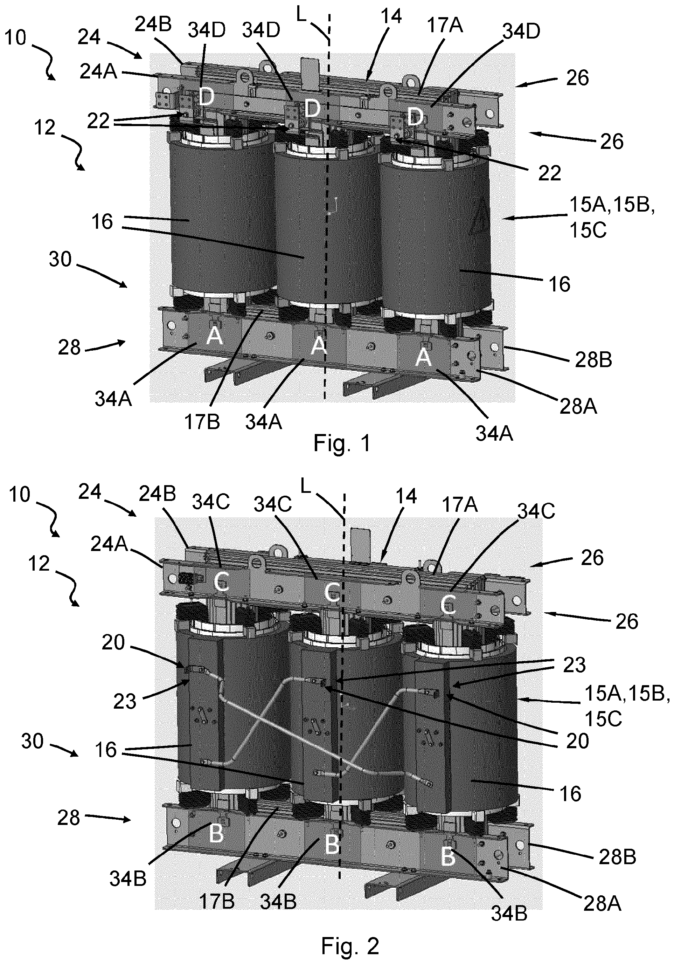

Figs. 1 to 3 show, in perspective and schematic illustrations, a system 10 according to an embodiment of the present disclosure. The system 10 includes a transformer 12 which includes at least one core 14 which has three phases in the embodiment shown in Figs. 1 to 3, each phase comprising a respective core leg 15A, 15B, 15C which is at least partially housed within a respective housing 16. The housing 16 may be at least partially made of a cured epoxy. The core 14 may comprise more or less than three core legs, for instance two, four, five or more core legs. The core legs, such as the core legs 15A, 15B, 15C, are sometimes also referred to as core limbs.

Each core leg 15A, 15B, 15C is connected to an adjacent core leg, respectively, via transverse sections 17A, 17B at the top and bottom of the core legs 15A, 15B, 15C, respectively. The transverse sections 17A, 17B are arranged substantially at a 90° angle to a longitudinal axis L of the core legs 15A, 15B, 15C, respectively.

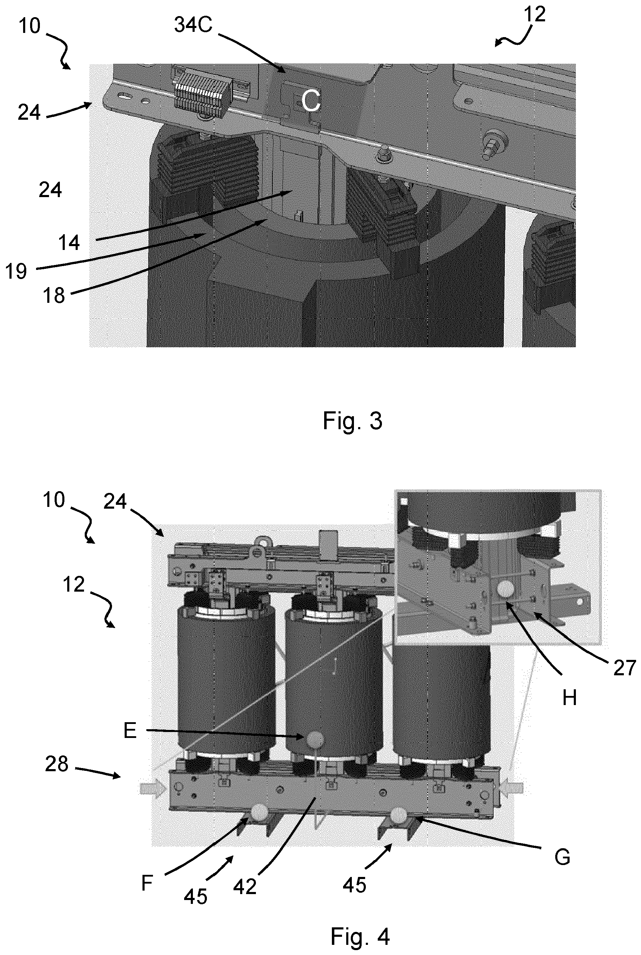

The transformer 12 further comprises, for each leg 15A, 15B, 15C, a first winding 18 and a second winding 19 (see Fig. 3). The second winding 19, and optionally also the first winding 18, may be at least partially embedded within a section of the housing 16. The respective first winding 18 may be wound around each leg 15A, 15B, 15C of the core 14 and the respective second winding 19 may be wound around the respective first winding 18. The first winding 18 may be a low voltage (LV) winding and the second winding 19 may be a high voltage (HV) winding. Fig. 3 exemplarily shows one first winding 18 and one second winding 19. The transformer 12 may include a plurality of first windings 18 and a plurality of second windings 19. As discussed above, the transformer 12 comprises a first winding 18 and a second winding 19 for each leg 15A, 15B, 15C.

The first winding 18 and the second winding 19 may be wound about a longitudinal axis L of each leg 15A, 15B, 15C, respectively, which is shown in an exemplary manner for one leg in Figs. 1 and 2. Thus, the longitudinal axis L may correspond to a winding axis about which the at least one first winding 18 and/or the at least one second winding 19 are wound, as shown in Figs. 1 and 2. Only one longitudinal axis L is depicted in Figs. 1 and 2 in an exemplary manner. Each core leg 15A, 15B, 15C may have a longitudinal axis L which may correspond to a winding axis about which the at least one first winding 18 and/or the at least one second winding 19 are wound. The transverse sections, such as the transverse sections 17A, 17B, are sometimes also be referred to as yokes.

The transformer 12 further comprises first leads 20 connected to the second windings 19 (see Fig. 2), respectively, the first leads 20 being connected to the transformer 12 at respective connection sections 23 on a circumference of the housings 16, respectively. The transformer 12 further comprises second leads 22 connected to the first windings 18 (see Fig. 1), respectively.

The transformer 12 further includes a top core clamp 24 arranged at, or at least towards, a first end 26 of the core 14 and a bottom core clamp 28 arranged at, or at least towards, a second end 30 of the core 14, the second end 30 of the core 14 being substantially opposite from the first end 26 of the core 14. The top core clamp 24 and the bottom core clamp 28 are configured to clamp the core 14 at the first end 26 and the second end 30, respectively. Each core clamp 24, 28 includes at least a first clamp structure 24A, 28A and at least a second clamp structure 24B, 28B. Moreover, each core clamp 24, 28 includes a tensioning device 27 configured to provide a tensioning force between the clamp structures 24A, 24B and 28A, 28B, respectively, to clamp the core 14 therebetween (see Fig. 4).

The system 10 further includes at least one voltage sensor 34 configured and arranged to sense a voltage through the second winding 19 by capacitive coupling. In other words, the at least one voltage sensor 34 is configured and arranged to sense a voltage from any of the second windings 19 by capacitive coupling, e.g., through proximity to one or more second windings 19.

Although Figs. 1 to 3 indicate a plurality of voltage sensors 34, i.e., voltage sensors 34A to 34D, this is generally meant to show a number of possible locations of the voltage sensor(s) 34, indicated by the letters "A", "B", "C" and "D", for arranging the at least one voltage sensor 34. However, the system may also include a plurality of voltage sensors 34 arranged at various locations, e.g., at one or more of the locations described below.

As can be seen in Fig. 1, the at least one voltage sensor 34 may be connected to a surface of the top core clamp 24 and/or the bottom core clamp 28 at position D and position A, respectively. As shown in Fig. 1, the surface of the respective core clamp 24, 28, to which the at least one voltage sensor 34 may be connected, faces in a direction away from the connection sections 23 of the leads 20 of the second windings 19. Alternatively, the location of the at least one voltage sensor 34 in locations A and D in Fig. 1 may be expressed as being arranged on a first side of a vertical central plane of the transformer 12, the first side being substantially opposite of a second side of the vertical central plane, the leads 20 of the second windings 19 being arranged on the second side. The vertical central plane may extend through each leg 15A, 15B, 15C and each transverse section 17A, 17B of the core 14.

As can be seen in Fig. 1, the voltage sensor 34 may be connected to the top core clamp 24 and/or the bottom core clamp 28 at a first angular location about the longitudinal axis L of each leg 15A, 15B, 15C of the core 14. The lead 20 of the second windings 19 is connected to the transformer 12 at a second angular location, wherein the first angular location is offset from the second angular location by a predetermined offset angle. For instance, the voltage sensors 34A and 34D may be offset by an offset angle of approximately 180°, as shown in Fig. 1, whereas the voltage sensors 34B and 34C in Fig. 2 are not angularly offset from the leads 20 of the second windings 19.

In locations A and D, the at least one voltage sensor 34 is arranged relatively far from the leads 20 of the second windings 19, respectively. As discussed towards the beginning, this may reduce the extent to which the voltage through the leads 20 of the second windings 19 and/or one or more cables and/or busbars connected to the leads 20 of the second windings 19, is sensed by the at least one voltage sensor 34. This may, for instance, increase the reliability and precision of a calibration process of the at least one voltage sensor 34, which generally does not take into account the voltage through the leads 20 of the second windings 19 and/or through one or more cables and/or busbars connected to the leads 20 of the second windings 19. Moreover, as discussed at the beginning, core clamps are generally earthed. Thus, connecting the at least one voltage sensor 34 to a surface of the core clamps 24, 28 may provide a region for the at least one voltage sensor 34 to reliably, safely and precisely, relatively speaking, sense the voltage through the second windings 19. Moreover, the core clamps 24, 28 may provide an attachment and/or guiding means for attaching and/or guiding one or more wires/cables which are connected to the at least one voltage sensor 34, e.g., for transmitting one or more signals to and/or from the at least one voltage sensor 34. In addition, one or more processing devices, in particular a central processing unit, may be attached and/or stowed in and/or on the core clamps 24, 28.

In locations B and C, the at least one voltage sensor 34 is generally arranged closer to the leads 20 of the second windings 19 compared with locations A and D. However, since the leads 22 of the first windings 18 are arranged on an opposite side of the transformer 12, with respect to the leads 20 of the second windings 19, the at least one voltage sensor 34 arranged in locations B and C is arranged further from the leads 22 of the first windings 18 compared with locations A and D. This may reduce the extent to which the voltage through the leads 22 of the first windings 18 and/or through one or more cables and/or busbars connected to the lead 22 of the first windings 18 is sensed by the at least one voltage sensor 34. In locations B and C, the at least one voltage sensor 34 is connected to a surface of the core clamps 24, 28, wherein the surface is arranged on the same side of a vertical central plane of the transformer 12 as the leads 20 of the second windings 19.

Fig. 4 shows an embodiment of the system 10 in which a variety of further possible locations of the at least one voltage sensor 34 is illustrated. As shown in Fig. 4, the at least one voltage sensor 34 may be arranged on an extension 42 attached to a section of the bottom core clamp 28, as indicated by location E in Fig. 4. This may allow the at least one voltage sensor 34 to be positioned relatively close to the second winding(s) 19, e.g., without having to directly attach the at least one voltage sensor 34 to the housing 16 of the transformer 12. The extension 42 may enable a precise positioning of the at least one voltage sensor 34 relative to the second windings 19, e.g., by adjusting the positioning and/or orientation of the extension 42 relative to the second windings 19. Alternatively, the at least one voltage sensor 34 may be arranged on supporting rails 45 on which the core 14 is supported, as indicated by locations F and G in Fig. 4. Further alternatively, the at least one voltage sensor 34 may be arranged within one of the core clamps 24, 28, e.g., at least partially between the clamp structures 24A, 24B and 28A, 28B, respectively, as indicated by location H in Fig. 4.

The transformer 12 of the system 10 shown in Figs. 1 to 4 is configured as a dry-type transformer, e.g., a transformer which is not immersed in a liquid, e.g., oil.

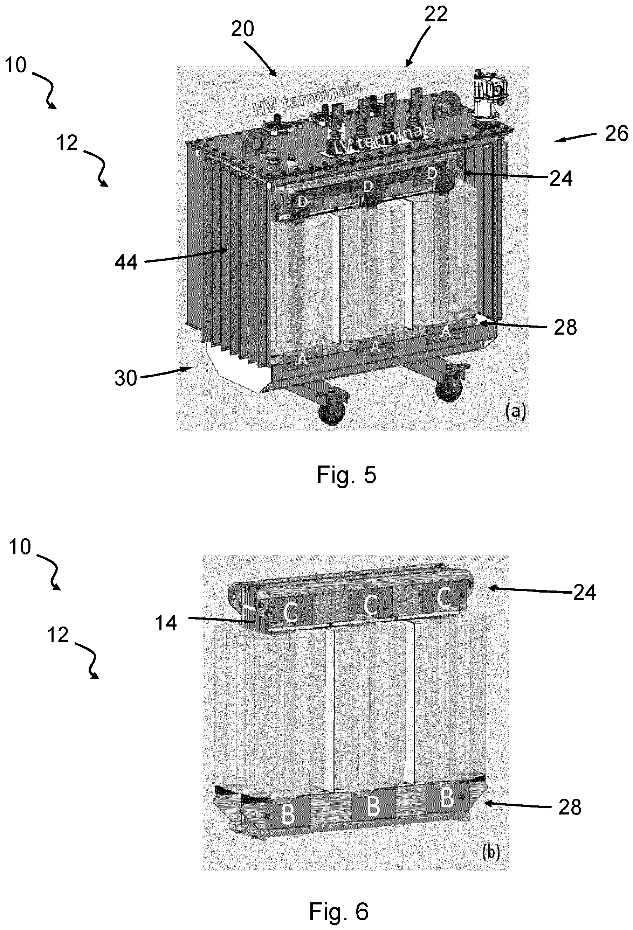

However, the system 10 described herein may also be configured with a liquid-cooled, e.g., a liquid-immersed, transformer, such as an oil-filled or oil-immersed transformer. Such a configuration of a system 10 is shown in Figs. 5 to 7, for example. Deviating from the system 10 shown in Figs. 1 to 4, the transformer 12 of the system 10 shown in Figs. 5 to 7 comprises at least one casing 44 configured to store or house at least one liquid, particularly oil, e.g., for cooling the transformer 12. The casing 44 may be configured as a tank, in particular an oil tank. The core legs 15A, 15B, 15C of the core 14 and the first windings 18 and second windings 19 are encompassed by the casing 44. As shown in the embodiment of Figs. 5 to 7, the system 10 includes a single casing 44. Alternatively, the system 10 may include a plurality of casings 44, wherein each casing 44 may individually at least partially house a respective core leg 15A, 15B, 15C and the associate first winding 18 and second winding 19, rather than providing a single casing to at least partially house each core leg and each first winding 18 and second winding 19. Thus, each casing 44 may be configured to house at least one liquid, particularly oil, e.g., for cooling the transformer 12.

The at least one voltage sensor 34 may, as shown in the embodiment of Figs 1 to 3, be arranged on one of the core clamps 24, 28. In deviation from the embodiment shown in Figs. 1 to 4, the leads 20 of the second windings 19 and the leads 22 of the first windings 18 are both arranged towards the first end 26 of the at least one core 14 in the embodiment shown in Figs. 5 to 7. Thus, in locations A and B, the at least one voltage sensor 34 is arranged relatively far, or at least further than locations C and D, from the leads 20 of the second windings 19 and the leads 22 of the first windings 18, respectively. As discussed towards the beginning, this may reduce the extent to which the voltage through the leads 20 of the second windings 19 and the leads 22 of the first windings 18 and/or one or more cables and/or busbars connected to the leads 20 of the second windings 19 and the leads 22 of the first windings 18, is sensed by the at least one voltage sensor 34.

However, arranging the at least one voltage sensor 34 at locations C and D is also feasible and may in fact increase the sensitivity of the at least one voltage sensor 34 with respect to sensing the voltage through the second windings 19. However, arranging the at least one voltage sensor 34 at locations C and D may require greater efforts directed towards insulation between the at least one voltage sensor 34 and the leads 20 of the second windings 19 and the leads 22 of the first windings 18. For instance, this may require a greater and/or more reliable insulation, e.g., an insulation material having a greater thickness and/or a higher quality insultation material, between the at least one voltage sensor 34 and the leads 20 of the second windings 19 and the leads 22 of the first windings 18, e.g., at least partially about the respective the leads 20 of the second windings 19 and the leads 22 of the first windings 18. If the at least one voltage sensor 34 is located further from the leads 20 of the second windings 19 and the leads 22 of the first windings 18, less effort directed towards the insulation may be required/sufficient compared with arranging the at least one voltage sensor 34 at locations C and/or D.

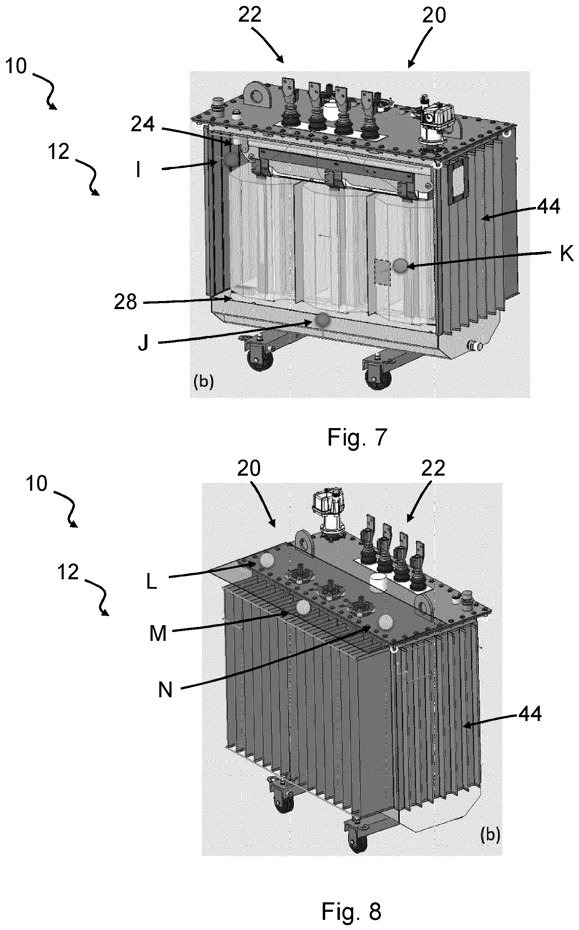

Instead of positioning the at least one voltage sensor 34 on a section of the core clamps 24, 28, e.g., at locations A to D as shown in Figs. 5 and 6, the at least one voltage sensor 34 may alternatively be positioned on a section of the casing 44, as shown in Fig. 7. In particular, the at least one voltage sensor 34 may be attached to an inner surface of the casing 44, e.g., facing towards the second winding(s) 19. Exemplary locations I to K are shown in Fig. 7. Alternatively, the at least one voltage sensor 34 may be attached to an outer surface or outer structure of the casing 44, e.g., on a top of the casing 44, as shown in Fig. 8. Exemplary locations L to N are shown in Fig. 8. In particular, when arranging the at least one voltage sensor 34 on an outer surface or outer structure of the casing 44, as shown in Fig. 8, in general, the at least one voltage sensor 34 may be configured/intended to detect a voltage at the leads 20 of the second windings 19 and/or at one or more cables and/or busbars attached to the leads 20 of the second windings 19. Hence, the at least one voltage sensor 34 may be arranged at or on a region of the casing 44 which is near or adjacent to the leads 20 of the second windings 19 and/or to one or more cables and/or busbars which are attached to the leads 20 of the second windings 19.

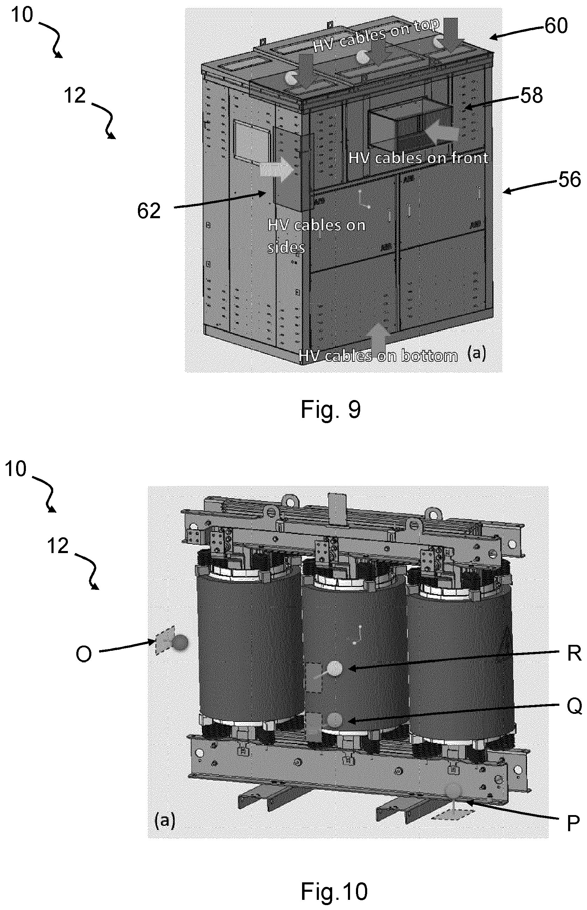

A dry-type transformer, such as the transformer 12 shown in Figs. 1 to 4, may also include a casing 56, similar to the casing 44 shown in Figs. 5 to 8. Fig. 9, for instance, shows an embodiment in which the transformer 12, e.g., a dry-type transformer, may be housed within the casing 56. Similar to the embodiments of the transformer 12 shown in Figs. 5 to 8, the at least one voltage sensor 34 may be attached on an outer surface or structure of the casing 56, as shown in Fig. 9. In particular, when arranging the at least one voltage sensor 34 on an outer surface or structure of the casing 56, in general, the at least one voltage sensor 34 may be configured/intended to detect a voltage at the leads 20 of the second windings 19 and/or at one or more cables and/or busbars which are attached to the leads 20 of the second windings 19, as discussed above with respect to Fig. 8. Thus, the at least one voltage sensor 34 may be attached to a region of the casing 56 which is near or adjacent to the leads 20 of the second windings 19 and/or to one or more cables and/or busbars which are attached to the leads 20 of the second windings 19. Since the one or more cables and/or busbars may enter through the casing towards the leads 20 at a plurality of different regions of the casing 56, accordingly, the at least one voltage sensor 34 may be attached to a number of different regions of the casing 56 near or adjacent to the one or more cables and/or busbars, as indicated by regions 58, 60 and 62 in Fig. 9. Alternatively, the at least one voltage sensor 34 may be attached to an inner surface of the casing 56, e.g., facing towards the second winding(s) 19, as indicated by locations O to R in Fig. 10. To better show the locations O to R in Fig. 10, the casing 56 has been omitted from the illustration in Fig. 10.

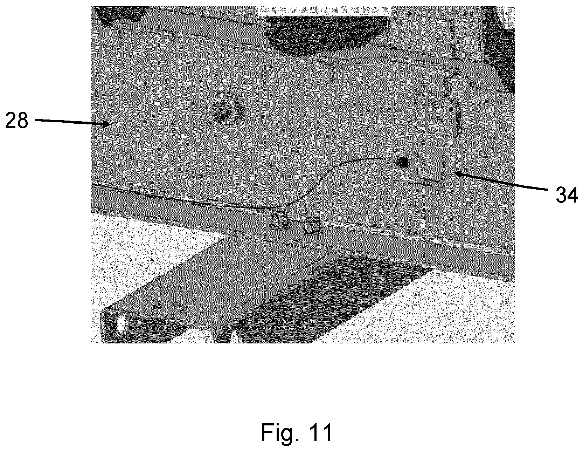

Fig. 11 shows an exemplary configuration of the at least one voltage sensor 34. In particular, the at least one voltage sensor 34 is configured as a patch and is integrated in a printed circuit board (PCB). The at least one voltage sensor 34 is attached to a surface of the bottom core clamp 28.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

## Claims

1. A system (10) comprising:
a transformer (12) comprising:
at least one first winding (18) wound around at least one core (14),
at least one second winding (19) wound around the at least one first winding (18), and
at least one voltage sensor (34) configured and arranged to sense a voltage through the at least one second winding (19) by capacitive coupling.

2. The system (10) of claim 1, further comprising the at least one core (14) and at least one first core clamp (24, 28) arranged at a first end of the at least one core (14) and configured to clamp the at least one core (14) at the first end, wherein the at least one voltage sensor (34) is connected to a surface of the at least one first core clamp (24, 28).

3. The system (10) of claim 2, wherein at least one lead (20) of the at least one second winding (19) is connected to the transformer at a connection section (23), wherein the surface of the at least one first core clamp (24, 28) to which the at least one voltage sensor (34) is connected:
faces in a direction away from the connection section (23);
and/or
is arranged on a first side of a vertical central plane of the transformer, the first side being substantially opposite of a second side of the vertical central plane, the at least one lead (20) being arranged on the second side.

4. The system (10) of claim 2 or 3, wherein the at least one voltage sensor (34) is arranged, particularly connected to the at least one first core clamp (24, 28), at a first angular location about a longitudinal axis (L) of the transformer and the at least one lead (20) is connected to the transformer at a second angular location, wherein the first angular location is offset from the second angular location by a predetermined offset angle.

5. The system (10) of any one of claims 2 to 4, wherein at least one voltage sensor (34) is connected to a surface of the transformer, particularly to a surface of the at least one first core clamp (24, 28), wherein the surface is arranged on the same side of a vertical central plane of the transformer as the at least one lead (20).

6. The system (10) of any one of claims 2 to 5, wherein the transformer comprises at least one second core clamp (24, 28) at a second end of the at least one core (14), the second end of the at least one core (14) being arranged substantially opposite of the first end of the at least one core (14), the second core clamp (24, 28) being configured to clamp the at least one core (14) at the second end of the at least one core (14), wherein the at least one voltage sensor (34) is connected to a surface of the at least one first core clamp (24, 28) and/or to a surface of the at least one second core clamp (24, 28).

7. The system (10) of any one of claims 1 to 6, wherein at least one lead (22) of the at least one first winding (18) is arranged at the first end or a second end of the at least one core (14), the second end being substantially opposite of the first end, wherein the at least one voltage sensor (34) is arranged at the other of the first end and the second end.

8. The system (10) of any one of claims 1 to 7, wherein the at least one voltage sensor (34) is attached to one end of the at least one core (14).

9. The system (10) of any one of claims 1 to 8,
wherein the transformer (12) further comprises at least one casing (44),
wherein the at least one casing (44) is connected to the at least one first core clamp (24, 28) and the at least one voltage sensor (34) is connected to the at least one casing (44), and
wherein the casing (44) houses the at least one second winding (19).

10. The system (10) of claim 9, wherein the at least one voltage sensor (34) is attached to an outer surface of the at least one casing (44).

11. The system (10) of any one of claims 8 to 10, wherein the at least one voltage sensor (34) is attached to an inner surface of the at least one casing (44), particularly facing the at least one second winding (19).

12. The system (10) of any one of claims 1 to 11, wherein the at least one voltage sensor (34) has a rounded shape, in particular a spherical, a hemispherical, a toroidal, or a hemi toroidal shape.

13. The system (10) of any one of claims 1 to 12, wherein the largest area of projection of the at least one voltage sensor (34) is no more than 500 cm2, particularly no more than 450 cm2, more particularly no more than 400 cm2, more particularly no more than 350 cm2, more particularly no more than 300 cm2, more particularly no more than 250 cm2, more particularly no more than 200 cm2.

14. The system (10) of any one of claims 1 to 13, wherein the largest spatial dimension of the at least one voltage sensor (34) is no more than 20 cm, particularly no more than 18 cm, more particularly no more than 16 cm, more particularly no more than 14 cm, more particularly no more than 12 cm.

15. The system (10) of any one of claims 1 to 14, wherein the at least one voltage sensor (34) has a spatial volume of no more than 700 cm3, particularly no more than 650 cm3, more particularly no more than 600 cm3, more particularly no more than 550 cm3, more particularly no more than 500 cm3.
